# DEMANDE DE BREVET EUROPEEN

(11) **EP 1 432 044 A1**
(43) Date de publication de la demande: **23.06.2004**
(21) Numéro de dépôt: 02080657.6
(22) Date de dépôt: 20.12.2002
(51) Int. Cl.: H01L 31/0216

(54) **Photodiode à filtre en polysilicium intégré**

(71) Demandeur: EM Microelectronic-Marin SA, 2074 Marin (CH)
(72) Inventeur: Willemin, Michel, CH-2523 Lignières (CH)
(74) Mandataire: Laurent, Jean

(57) **Abrégé**

Le dispositif de détection de lumière (1) comprend un caisson (3) d'un premier type de conductivité réalisé dans un substrat semi-conducteur (2) d'un second type de conductivité, une couche isolante (4) déposée sur une face du caisson et du substrat semi-conducteur et au moins une couche de poly-silicium (7) déposée sur la couche isolante pour recouvrir au moins partiellement le caisson. Une diode (12) est définie entre le caisson (3) et le substrat semi-conducteur (2) pour la génération d'un courant dépendant de la lumière captée notamment par le caisson du dispositif. La couche de poly-silicium (7) est utilisée comme un filtre pour ne laisser passer à travers la couche de poly-silicium qu'une gamme déterminée de longueurs d'onde de la lumière (10) à capter. Ledit filtre est de préférence transparent aux infrarouges.

## Description

L'invention concerne un dispositif de détection de lumière à filtre intégré qui peut être réglable. Le dispositif de détection de lumière comprend un caisson d'un premier type de conductivité réalisé dans un substrat semi-conducteur d'un second type de conductivité et au moins une couche de poly-silicium pour recouvrir au moins partiellement le caisson. Une diode est définie entre le caisson et le substrat semi-conducteur pour la génération d'un courant dépendant de la lumière captée notamment par le caisson du dispositif. La diode est connectée par exemple à une source de tension afin d'être inversement polarisée. Une couche isolante est de préférence déposée sur une face du caisson et du substrat semi-conducteur afin que la couche de poly-silicium soit déposée sur la couche isolante.

Des dispositifs de détection de lumière sont par exemple des photodiodes ou des capteurs d'image qui sont réalisés de préférence dans un substrat semi-conducteur en silicium. Les capteurs d'image ont présenté un essor très important ces dernières années. La tendance initiée par les capteurs de type CCD (Charge-Coupled Device en terminologie anglaise) a été accentuée par l'apparition de capteurs de type CMOS sur le marché. Les performances de la technologie CMOS, en particulier la maîtrise de la densité de courant de fuite, ainsi que la finesse et la précision de l'implantation, ont permis de concurrencer les capteurs CCD intrinsèquement plus chers que les capteurs CMOS. En effet, une matrice de pixels CCD requiert une technologie spéciale, ce qui n'est à priori pas le cas pour des pixels CMOS.

Les photodiodes ou capteurs d'images CMOS présentent un avantage par rapport aux capteurs CCD. Ils permettent d'ajouter une intelligence, constituée par un circuit électronique supplémentaire, au niveau des pixels. Un pré-traitement rapide de l'information devient ainsi possible.

Le pixel CMOS contient généralement un élément de base photosensible qui est une jonction pn (photodiode). Le courant généré par la photodiode, qui dépend de la lumière reçue ou de l'illumination de celle-ci, est habituellement intégré et converti en une tension par des composants électroniques habituels. Par exemple, le pixel CMOS APS (Active Pixel Sensor en terminologie anglaise) minimal contient une photodiode et 3 transistors MOS. Ce pixel contient également un amplificateur très sommaire (source suiveur).

Le traitement électronique de l'information est certes très important, mais dans certains cas, il convient d'effectuer un traitement en amont de la photodiode, c'est-à-dire au niveau optique. Cela est couramment utilisé dans les capteurs d'images couleurs. La matrice de pixels est organisée sous la forme d'une structure de pixels sensibles à différentes longueurs d'ondes (rouge, vert , bleu). Il existe différentes variantes de structures choisies en fonction des performances souhaitées.

Pour pouvoir filtrer des longueurs d'onde de lumière souhaitées, l'introduction de filtres optiques intégrés sur une matrice de pixels est une pratique courante. Leur réalisation est possible par différents procédés, comme l'application de résines pigmentées ou de filtres interférentiels. Ces techniques font donc appel à une réalisation ou un traitement ultérieur ce qui est un inconvénient pour diverses raisons. D'une part, cela conduit à une augmentation du prix du produit réalisé, et d'autre part le rendement ne peut qu'être dégradé.

L'apparition de technologies fines complique encore l'usage de filtres réalisés dans des étapes ultérieures de fabrication en raison des faibles tailles latérales par rapport à la hauteur de toutes les couches. La sélection de la longueur d'onde est également possible sans ajouter de filtres sur les pixels, mais directement par le choix de type de pixel implémenté. Le type de jonction, et notamment la profondeur de la zone de déplétion de la jonction pn, auront une influence directe sur la réponse spectrale du pixel. Les photons pénètrent plus au moins profondément dans le silicium selon leur longueur d'onde. Ce phénomène physique est décrit par la loi de Beer.

L'invention a donc pour but de fournir un dispositif de détection de lumière dans lequel un filtre intégré est réalisé simplement par une technologie traditionnelle, notamment du type CMOS, afin de pallier les inconvénients de l'art antérieur cité ci-devant. Le filtre intégré peut être également réglable en fonction de la gamme de longueurs d'onde de lumière à filtrer.

A cet effet, l'objet de l'invention concerne un dispositif de détection de lumière cité ci-devant qui se caractérise en ce que la couche de poly-silicium est utilisée comme un filtre pour ne laisser passer à travers la couche de poly-silicium qu'une gamme déterminée de longueurs d'onde de la lumière à capter.

Un avantage du dispositif de détection de lumière, selon l'invention, est qu'il n'est pas nécessaire de réaliser un tel filtre par des étapes supplémentaires de fabrication. Ce filtre intégré est réalisé dans une même étape de fabrication du dispositif que par exemple des grilles de transistors MOS nécessaires pour le traitement du courant généré par la photodiode. Cette photodiode est constituée par le substrat semi-conducteur, notamment en silicium, et le caisson réalisé dans le substrat, le caisson étant d'un type de conductivité différent du substrat.

Le filtre optique réalisé avec la couche de poly-silicium possède une caractéristique de type passe-bas en considérant la fréquence de l'onde électromagnétique de la lumière reçue. De plus, la couche de poly-silicium doit être normalement de type non silicuré afin de présenter un aspect non-métallique et assurer une transparence du filtre aux longueurs d'onde dans le domaine infrarouge. Le filtre ne laisse en principe passer que la lumière de longueur d'onde supérieure à 650 nm notamment dans le domaine infrarouge proche. Comme le dispositif est réalisé de préférence dans un substrat en silicium, la lumière de longueur d'onde supérieure à 1000 nm ne peut que difficilement être détectée dans le silicium.

Un autre avantage du dispositif de détection de lumière, selon l'invention, est que la couche de poly-silicium peut être structurée de telle manière à ne recouvrir qu'une portion de surface de la partie du caisson captant la lumière. Ainsi, le rapport entre la portion de surface couverte par la couche de poly-silicium et la surface de la partie du caisson captant la lumière détermine le taux d'atténuation dans le visible, qui est réglable. Ainsi, on peut considérer ce taux d'atténuation comme si la longueur d'onde de coupure du filtre constitué notamment par la couche de poly-silicium est changée.

Pour le réglage du taux d'atténuation dans le visible, la couche de poly-silicium peut être structurée sous forme de bandes d'une largeur déterminée et régulièrement espacées sur la partie du caisson captant la lumière. Cette couche de poly-silicium peut être également structurée sous forme d'un treillis constitué d'une pluralité d'ouvertures de dimension identique et régulièrement espacées sur la partie du caisson captant la lumière. La structure particulière de la couche de poly-silicium permet donc d'obtenir un filtre réglable dont le taux d'atténuation ou la longueur d'onde de coupure dépend de la couverture du caisson par la couche de poly-silicium.

Bien entendu, si la couche de poly-silicium recouvre toute la partie du caisson captant la lumière, ledit caisson ne reçoit que la lumière dans la gamme de longueurs d'onde située notamment entre 650 nm et 1000 nm de l'infrarouge proche dans un substrat en silicium. Une borne de contact électrique doit en principe venir connecter le caisson par l'intermédiaire d'une couche plus fortement dopée du même type de conductivité que le caisson. De ce fait, la couche de poly-silicium ne peut pas couvrir l'intégralité du caisson à moins qu'elle serve également de contact électrique dudit caisson.

Les buts, avantages et caractéristiques du dispositif de détection de lumière apparaîtront mieux dans la description suivante de formes d'exécution illustrées par les dessins sur lesquels :
la figure 1 représente schématiquement une vue en coupe verticale du dispositif de détection de lumière, tel qu'une photodiode, selon l'invention,
les figures 2a à 2c représentent de manière simplifiée en vue de dessus trois formes d'exécution du filtre optique sur le caisson en fonction de structures particulières de la couche de poly-silicium, et
la figure 3 représente un graphique de l'effet de la couche de poly-silicium recouvrant entièrement ou partiellement le caisson de la photodiode sur le rendement quantique en fonction de la longueur d'onde de la lumière.

Dans la description suivante, il est à noter que tous les éléments du dispositif de détection de lumière, qui sont bien connus de l'homme du métier dans ce domaine technique, ne sont relatés que de manière simplifiée. Le dispositif de détection de lumière n'est décrit ci-après qu'en relation à une photodiode munie d'un filtre intégré transparent aux infrarouges. Bien entendu, le dispositif peut comprend encore un circuit électronique, non représenté, pour convertir notamment le courant généré par la lumière dans la photodiode. De plus, en lieu et place d'une photodiode, il pourrait être imaginé d'utiliser un phototransistor comme élément sensible.

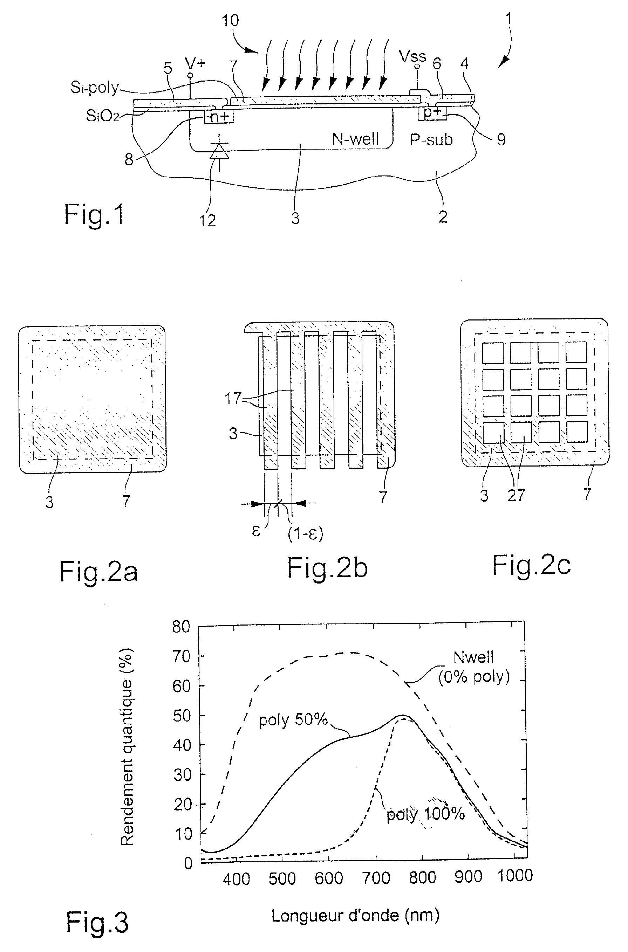

Le dispositif de détection de lumière 1, représenté à la figure 1, est une photodiode. Le dispositif comprend un caisson 3 de type N réalisé dans un substrat semi-conducteur 2 en silicium de type P. Sur le caisson 3 et le substrat 2, une couche isolante 4 est déposée. Cette couche isolante peut être de préférence une couche d'oxyde de silicium SiO2. Toutefois cette couche isolante peut aussi être constituée par tout autre matériau isolant, tel que du nitrure de silicium Si3N4. Sur la couche isolante et au-dessus du caisson, une couche de poly-silicium 7 est déposée afin de servir de filtre pour capter de la lumière 10 dans une gamme déterminée de longueurs d'onde. Cette gamme de longueurs d'onde peut être entre 650 nm à 1000 nm (infrarouge proche) avec une couche de poly-silicium non silicuré.

Une diode 12 est définie entre le caisson 3 et le substrat semi-conducteur 2. Cette diode 12 doit être connectée notamment à une source de tension, non représentée, afin d'être inversement polarisée. Pour la connexion de cette diode, une première borne métallique de contact 5 vient connecter le caisson 3 par une ouverture faite dans la couche isolante 4. Pour assurer un bon contact de la première borne 5 au caisson, une première couche 8 fortement dopée du type N est réalisée dans le caisson. Cette première borne de contact 5 est reliée par une piste métallique à une borne positive V+ d'une source de tension. Une seconde borne métallique de contact 6 vient connecter le substrat semi-conducteur 2 par une ouverture faite dans la couche isolante 4. Comme pour la première borne de contact 5, une seconde couche 9 fortement dopée de type P est réalisée dans le substrat semi-conducteur 2. Cette seconde borne de contact 6 est reliée par une piste métallique à une borne négative Vss de la source de tension. Ainsi en fonctionnement normal, la diode 12 peut être inversement polarisée afin qu'un courant, généré par la lumière 10 captée par le caisson, puisse circuler à travers la diode. Ce courant est normalement intégré et converti en une tension par un circuit électronique non représenté, mais pouvant faire partie d'un même circuit intégré que la photodiode.

La couche de poly-silicium 7 peut être connectée à la seconde borne de contact 6. Avec un potentiel variable appliqué sur la couche de poly-silicium, il est possible de modifier la zone de déplétion de la diode 12.

La couche de poly-silicium 7 constituant le filtre optique présente une caractéristique de passe-bas en considérant la fréquence f de l'onde électromagnétique. Dans une représentation en fonction de la longueur d'onde λ, la caractéristique spectrale présente donc une faible transmission aux courtes longueurs d'onde et une transmission proche de 100% aux grandes longueurs d'ondes (λ = c/f). Ce genre de transmission spectrale est très utile pour le rejet de courtes longueurs d'onde.

Un tel filtre avec une longueur d'onde de coupure voisine de la transition entre les domaines visible et infrarouge proche (IRA) du spectre a été obtenu en recouvrant la photodiode classique de la couche de poly-silicium 7. Il est à noter que les photodiodes classiques sont généralement sensibles sur un relativement large domaine spectral allant du bleu (λ = 350 nm) à l'infrarouge (λ = 1000 nm). L'infrarouge plus lointain (IRB et IRC) n'est que très difficilement accessible pour des dispositifs de détection de lumière au silicium conventionnels. Comme expliqué ci-dessus, la photodiode peut s'obtenir par la jonction entre le caisson 3 du type N et le substrat semi-conducteur 2 du type P dans une technologie CMOS classique par exemple à 0,5 µm. Si le caisson 3 est entièrement recouvert par la couche de poly-silicium 7, la longueur d'onde de coupure du filtre sera de l'ordre de 650 à 750 nm.

Pour un grand nombre d'applications dans l'infrarouge proche (IRA), la contribution d'une grande partie du spectre comme le visible, n'est pas souhaitée. Les exemples les plus fréquents sont les applications combinant un émetteur infrarouge (LED-IR) à un photo-détecteur (photodiode ou photo-ASIC). Dans un tel cas, seule la détection du signal infrarouge émis présente un intérêt. Toute contribution d'une source de lumière externe peut être considérée comme un signal parasite. Des illustrations typiques sont à trouver dans des barrières optiques, des détecteurs de pluie intégrés aux pare-brise de véhicules. Pour de telles applications, le rejet du signal parasite doit être effectué soit au niveau optique, soit au niveau électronique. Il est souvent nettement préférable d'éliminer tout signal parasite le plus en amont de la chaîne de traitement de l'information. Par conséquent, la solution du filtre optique est souvent préférée, c'est pourquoi il a été imaginé de créer un filtre avec la couche de poly-silicium 7.

La longueur d'onde de coupure du filtre (entre 650 nm et 750 nm) est déterminée par la couche de poly-silicium 7, si cette couche recouvre entièrement la partie du caisson captant la lumière. Cette valeur de coupure est appropriée pour la plupart des applications. En effet la grande partie du spectre visible solaire est ainsi rejetée, alors que le filtre reste transparent aux longueurs d'onde de la plupart des diodes électroluminescentes IR. Le taux d'atténuation dans le visible est parfaitement réglable par la proportion de surface du caisson de la photodiode recouvert de la couche de poly-silicium 7.

Les figures 2a à 2c montrent de manière simplifiée trois structures différentes de la couche de poly-silicium 7 recouvrant le caisson 3 de la photodiode.

Dans une première forme d'exécution montrée à la figure 2a, la couche de poly-silicium recouvre entièrement le caisson, ce qui a pour conséquence que le filtre ainsi réalisé ne reste transparent qu'à la lumière de longueurs d'onde dans le domaine infrarouge proche.

Il peut toutefois être souhaité qu'une partie de la lumière dans le domaine du visible soit également captée par le caisson 3 de la photodiode. Ainsi à la figure 2b, une seconde forme d'exécution de la couche de poly-silicium 7 est montrée. Cette couche de poly-silicium 7 est structurée dans cette seconde forme d'exécution sous forme de bandes 17. Les bandes 17 ont normalement chacune une largeur déterminée et sont régulièrement espacées sur la partie du caisson captant la lumière. La largeur de chaque bande vaut ε alors que l'espace entre chaque bande vaut 1-ε. De préférence, la largeur de chaque bande est équivalente à l'espace entre chaque bande de manière à avoir une couverture du caisson par la couche de poly-silicium de 50%.

Avec une couverture partielle de la partie du caisson captant la lumière, le taux d'atténuation dans le domaine visible peut être réglé, comme si la longueur de coupure du filtre est modifiée.

Une troisième forme d'exécution est présentée à la figure 2c. Dans ce cas, la couche de poly-silicium 7 est structurée sous forme d'un treillis constitué d'une pluralité d'ouvertures 27 de dimension identique et régulièrement espacées sur la partie du caisson 3 captant la lumière. Ces ouvertures peuvent être circulaires ou rectangulaires. En comparaison à la seconde forme d'exécution de la figure 2b, le filtre se comporte de manière plus homogène dans toutes les directions d'un faisceau lumineux à capter. Cette homogénéisation est fonction spécifiquement de l'épaisseur de la couche de poly-silicium de la technologie employée.

A la figure 3, il est présenté trois courbes du rendement quantique par rapport aux longueurs d'onde de la lumière pour montrer l'effet de la couche de poly-silicium sur la partie du caisson captant la lumière. On entend par rendement quantique le rapport entre le nombre de paires électron-trou générées et le nombre de photons incidents à la surface du caisson.

La courbe Nwell correspond à un caisson non recouvert par un filtre constitué par une couche de poly-silicium. Comme montré sur la courbe poly 50%, une atténuation d'environ 50% dans le visible peut être obtenue par une couverture partielle du caisson de la photodiode notamment en technologie CMOS à 0,5 µm. La couche de poly-silicium est organisée dans ce cas en bandes avec rapport cyclique 50%/50%, comme montré à la figure 2b. Une couverture totale du caisson de la photodiode, comme montré par la courbe poly, conduirait à un rejet maximal du spectre visible par rapport au rayonnement infrarouge proche (IRA).

La base physique du phénomène est explicable en utilisant la loi de Beer. Cette loi de Beer (intensité lumineuse) est définie par la formule I(x) = I₀e⁻^{*a*}^{x}, où *a* est le coefficient d'absorption [m⁻¹], x détermine la profondeur depuis la surface du caisson [m], et I₀ est l'intensité de la lumière à la surface du caisson.

Les photons à grande longueur d'onde pénètrent plus profondément la matière pour former des paires électron-trou. Par opposition, la longueur de pénétration de photons hautement énergétiques, c'est-à-dire à faible λ sera relativement petite et, par conséquent, les porteurs de charges ne pourront être détectés. Dans l'exemple décrit ci-dessus, seuls les photons ayant une longueur d'onde suffisante formeront des paires électron-trou proche de la jonction entre le caisson et le substrat semi-conducteur, et auront ainsi une forte probabilité d'être séparés, donc détectés. Les paires électron-trou formées dans la couche de poly-silicium se re-combinent et ne pourront pas générer de signal décelable.

Il est bien clair que le dispositif de détection de lumière n'est évidemment pas limité au cas particulier de la technologie à 0,5 µm. D'autres procédés CMOS permettent d'exploiter également l'implantation de filtres en poly-silicium en surface ce qui permet ainsi d'optimiser la détection infrarouge en rejetant un maximum du rayonnement visible.

A partir de la description qui vient d'être faite, de multiples variantes de réalisation de dispositif de détection de lumière peuvent être conçues par l'homme du métier sans sortir du cadre de l'invention. Le caisson peut être de type P, alors que le substrat semi-conducteur peut être de type N. Il peut être envisagé que la couche de poly-silicium soit connectée au caisson plutôt qu'au substrat semi-conducteur.

## Revendications

1. Dispositif de détection de lumière (1) comprenant un caisson (3) d'un premier type de conductivité réalisé dans un substrat semi-conducteur (2) d'un second type de conductivité et au moins une couche de poly-silicium (7) pour recouvrir au moins partiellement le caisson, une diode (12) étant définie entre le caisson (3) et le substrat semi-conducteur (2) pour la génération d'un courant dépendant de la lumière captée notamment par le caisson du dispositif, **caractérisé en ce que** la couche de poly-silicium (7) est utilisée comme un filtre pour ne laisser passer à travers la couche de poly-silicium qu'une gamme déterminée de longueurs d'onde de la lumière (10) à capter.

2. Dispositif selon la revendication 1, **caractérisé en ce qu'**une partie du caisson (3) captant la lumière est entièrement recouverte par la couche de poly-silicium (7) pour que le caisson ne capte que de la lumière de longueurs d'onde dans le domaine infrarouge.

3. Dispositif selon la revendication 2, **caractérisé en ce que** la longueur d'onde de coupure du filtre de type passe-bas constitué par la couche de poly-silicium (7) est de l'ordre de 650 à 750 nm.

4. Dispositif selon la revendication 1, **caractérisé en ce que** la couche de poly-silicium (7) est structurée de telle manière à ne recouvrir qu'une portion de surface de la partie du caisson (3) captant la lumière, le rapport entre la portion de surface couverte par la couche de poly-silicium et la surface de la partie du caisson captant la lumière déterminant un taux d'atténuation dans le domaine visible.

5. Dispositif selon la revendication 4, **caractérisé en ce que** la couche de poly-silicium (7) est structurée sous forme de bandes (17) d'une largeur déterminée et régulièrement espacées sur la partie du caisson captant la lumière.

6. Dispositif selon la revendication 4, **caractérisé en ce que** la couche de poly-silicium (7) est structurée sous forme d'un treillis constitué d'une pluralité d'ouvertures (27) de dimension identique et régulièrement espacées sur la partie du caisson (3) captant la lumière.

7. Dispositif selon la revendication 1, **caractérisé en ce que** le premier type de conductivité du caisson (3) est de type N, alors que le second type de conductivité du substrat semi-conducteur (2) en silicium est de type P, et **en ce que** la couche de poly-silicium (7) est non silicurée.

8. Dispositif selon l'une des revendications précédentes, **caractérisé en ce qu'**une première borne de contact de la diode (V+) connecte le caisson (3) par l'intermédiaire d'une première couche fortement dopée (8) du premier type de conductivité qui est réalisée dans le caisson (3), et **en ce qu'**une seconde borne de contact (Vss) de la diode (12) connecte le substrat semi-conducteur (2) par l'intermédiaire d'une seconde couche fortement dopée (9) du second type de conductivité.

9. Dispositif selon la revendication 8, **caractérisé en ce que** la couche de poly-silicium (7) est connectée à la seconde borne de contact (Vss).

10. Dispositif selon la revendication 1, **caractérisé en ce qu'**une couche isolante (4) est déposée sur une face du caisson et du substrat semi-conducteur afin que la couche de poly-silicium (7) soit déposée sur la couche isolante pour recouvrir au moins partiellement le caisson (3), et **en ce que** ledit dispositif est un circuit intégré réalisé dans une technologie CMOS à 0,5 µm ou inférieure.
